# EUROPEAN PATENT APPLICATION

(11) **EP 4 841 276 A1**
(43) Date of publication of application: **18.11.2026**
(21) Application number: 25877681.4
(22) Date of filing: 18.09.2025
(51) Int. Cl.: G01R 31/367, G01R 31/382, G01R 31/396, G01R 31/385, H01M 10/48, G06N 20/00, G01R 19/00

(54) **DEVICE AND METHOD FOR PREDICTING CELL CAPACITY**

(30) Priority: 07.10.2024 KR 20240135303
(71) Applicant: LG Energy Solution, Ltd., Seoul 07335 (KR)
(72) Inventor: KIM, Gyeongmo, Daejeon 34122 (KR)
(74) Representative: Goddar, Heinz J.
(86) International application number: PCT/KR2025/014534
(87) International publication number: WO 2026/079708

(57) **Abstract**

A method for predicting a capacity of a battery cell according to an embodiment of the present invention may comprise the steps of: measuring cell-related information during an activation process; compressing temperature profile data among the cell-related information to extract a temperature latent variable; and inputting activation process data including the temperature latent variable into a pre-trained machine learning model to produce a cell capacity prediction value.

## Description

### [Technical Field]

This application claims priority to and the benefit of Korean Patent Application No.10-2024-0135303 filed in the Korean Intellectual Property Office on October 7, 2024 the entire contents of which are incorporated herein by reference.

The present invention relates to an apparatus and method for estimating cell capacity, and more particularly, to an apparatus and method for estimating cell capacity based on temperature data compressed using an auto-encoder.

### [Background Art]

Secondary batteries, capable of recharging and reuse, may be used as an energy source for small devices such as mobile phones, tablet PCs and vacuum cleaners, and also used as an energy source for medium and large devices such as personal mobility, vehicles, and an energy storage system (ESS) for smart grids. Secondary batteries may be applied to a system in the form of an assembly such as a battery module in which a plurality of battery cells are connected in series/parallel or a battery pack in which battery modules are connected in series/parallel according to system requirements.

The capacity of a secondary battery refers to the amount of electrical energy that can be used until the battery is discharged and no longer capable of carrying current. The capacity of a secondary battery may be measured using various methods. One method involves discharging the battery after degassing during an activation process and prior to charging before shipping, determining the resulting discharge capacity as the battery capacity. Another method involves charging the battery until its state of charge (SOC) reaches 100% after it is completely discharged, and then calculating the capacity by accumulating the charging current flowing into the battery during this process.

However, because entire measurement of battery cell capacity is impossible, a method of estimating cell capacity using data generated during the activation process is utilized. Therefore, there is a need to improve the correlation between an estimated value and an actual value.

Among the prior art documents relevant to the present invention, KR 10-2020-0113762 A is of some relevance.

### [Detailed Description of the Invention]

### [Technical Problem]

To obviate one or more problems of the related art, embodiments of the present disclosure provide a method for estimating capacity of a battery cell.

To obviate one or more problems of the related art, embodiments of the present disclosure also provide a battery cell capacity estimation apparatus using the method.

### [Technical Solution]

In order to achieve the objective of the present disclosure, a method for estimating capacity of a battery cell may include measuring cell-related information during an activation process of the battery cell; extracting one or more temperature latent variables by compressing temperature profile data from the cell-related information; and inputting activation process data including the one or more temperature latent variables into a pre-trained machine learning model to generate a cell capacity estimation value.

The extracting of the one or more temperature latent variables by compressing the temperature profile data from the cell-related information may include inputting the temperature profile data into an auto-encoder; and extracting the one or more temperature latent variables as a result of encoding by the auto-encoder.

Here, the machine learning model may be pre-trained using cell-related data including a compressed temperature latent variable as training data.

The temperature latent variable may be a characteristic parameter of cell temperature profile data, expressed as six-dimensional data.

Here, the auto-encoder may be pre-trained using battery mass production data as input data, and using a six-dimensional latent vector.

In addition, the activation process data may include the one or more temperature latent variables, and the cell discharge capacity, the cell charge capacity, and the average discharge voltage during cell discharge which are measured during the activation process.

Meanwhile, the cell-related data used as the training data may include one or more temperature latent variables, cell discharge capacity measured during an activation process, cell charge capacity, an average discharge voltage during cell discharge, and an actual cell capacity.

According to another embodiment of the present disclosure, an apparatus for estimating capacity of a battery cell may include at least one processor; and a memory configured to store at least one instruction executed by the at least one processor.

The at least one instruction may include instruction to measure cell-related information during an activation process of the battery cell; an instruction to extract one or more temperature latent variables by compressing temperature profile data from the cell-related information; and an instruction to input activation process data including the one or more temperature latent variables into a pre-trained machine learning model to generate a cell capacity estimation value.

The instruction to extract the one or more temperature latent variables by compressing the temperature profile data from the cell-related information may include an instruction to input the temperature profile data into an auto-encoder; and an instruction to extract the one or more temperature latent variables as a result of encoding by the auto-encoder.

Here, the machine learning model may be pre-trained using cell-related data including a compressed temperature latent variable as training data.

The temperature latent variable may be a characteristic parameter of cell temperature profile data, expressed as six-dimensional data.

Here, the auto-encoder may be pre-trained using battery mass production data as input data, and using a six-dimensional latent vector.

In addition, the activation process data may include the one or more temperature latent variables, and the cell discharge capacity, the cell charge capacity, and the average discharge voltage during cell discharge which are measured during the activation process.

Meanwhile, the cell-related data used as the training data may include one or more temperature latent variables, cell discharge capacity measured during an activation process, cell charge capacity, an average discharge voltage during cell discharge, and an actual cell capacity.

### [Advantageous Effects]

According to embodiments of the present disclosure, the correlation between estimated cell capacity value and actual cell capacity value can be improved.

Consequently, the over-detection and under-detection rates for defect detection in cell capacity can be improved.

### [Brief Description of the Drawings]

FIG. 1 is a schematic diagram of a battery manufacturing process to which the present invention may be applied.
FIGS. 2a and 2b are conceptual diagrams of a temperature profile reduction operation using an auto-encoder according to embodiments of the present invention.
FIG. 3 is a diagram conceptually illustrating the operating principle of the auto-encoder applied to the present invention.
FIG. 4 is a conceptual diagram of a cell capacity estimation method using a machine learning model trained using a compressed temperature profile, according to embodiments of the present invention.
FIG. 5 is a flowchart illustrating a cell capacity estimation method according to embodiments of the present invention.
FIG. 6 is a block diagram of a cell capacity estimation apparatus according to embodiments of the present invention.

100: cell capacity estimation apparatus
200: auto-encoder
300: Machine Learning Model

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, exemplary embodiments of the present invention will be described in detail with reference to the accompanying drawings.

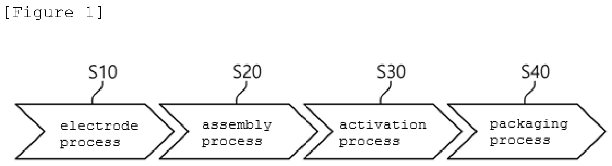

FIG. 1 is a schematic diagram of a battery manufacturing process to which the present invention may be applied.

In general, batteries are manufactured through an electrode process, an assembly process, and an activation/inspection process.

Batteries may be manufactured through an electrode process (S10), an assembly process (S20), an activation process (S30), and a packaging process (S40). The completed battery, which undergoes these processes, is shipped in the form of a battery pack (or battery module) including a plurality of battery cells connected in series. The battery pack may be connected to a load through the positive and negative terminals and perform charge/discharge operations. Depending on the requirements of a system in which the battery is used, the battery may be connected in series or parallel.

More specifically, the electrode process (S10) involves inputting raw materials and mixing active material, conductive material, and binder that constitute the electrode to form the positive and negative electrodes. The assembly process (S20) involves assembling the positive and negative electrode plates manufactured through the electrode process, along with the separator, to create a finished cell, a manufacturing order of which varies depending on the battery type (cylindrical, pouch, or prismatic), and the technologies employed vary by manufacturer. Furthermore, the activation process (S30) activates electrical energy and verifies stability. The final packaging process (S40) involves modularizing the manufactured battery cells and placing them into battery packs.

Meanwhile, the activation process (S30) may involve repeated aging and charging/discharging. During the aging process, the battery is stored at room temperature with a constant temperature and humidity to allow the electrolyte to permeate the positive and negative electrodes. Once the electrolyte is dispersed within the battery and ion movement between the positive and negative electrodes becomes smooth, the battery is partially charged to activate the cell. During this process, lithium ions migrate to the negative electrode and the electrolyte decomposes, forming a thin, ion-conductive solid layer, called the "Solid Electrolyte Interphase (SEI)" on the negative electrode surface. The SEI prevents electron movement and allows only lithium ions to pass through, which is a critical factor that enhances battery safety and influences battery performance and lifespan.

Charged batteries undergo a secondary aging process at high temperatures of 40 to 70°C, which stabilizes the SEI and establishes a more uniform thickness. During aging and charging, gases may be generated within the battery. This gas can be removed through degassing. Meanwhile, degassing may be omitted depending on the battery type, for example for cylindrical batteries.

After degassing, the aging and charging process may be repeated several more times. Afterwards, the battery capacity is determined through a charge/discharge process and defective batteries may be screened. Finally, just before shipment, the battery may undergo a shipping discharge process or a shipping charge process at a specified charge rate (typically 0.1 to 1C (C-rate)), completing the activation process. Here, a shipping discharge method discharges the battery directly to a shipping SOC without going through a full discharge process, to achieve the shipping SOC. Furthermore, a shipping charge method recharges the battery cell to the shipping SOC after fully discharging it.

Here, the charge rate (C-rate) is a value indicating a rate at which the battery is charged or discharged, also known as a charge/discharge rate. The unit for the charge rate is C (Capacity). The charge rate (C-rate) is calculated by dividing the charge/discharge current (A) by the battery's rated capacity (Ah), with a standard value of 1C.

Meanwhile, during a charge/discharge process in the activation process, data such as cell temperature, discharge capacity, charge capacity, and actual capacity may be collected. The present invention provides a method for more accurately estimating cell capacity using data collected during this charge/discharge process.

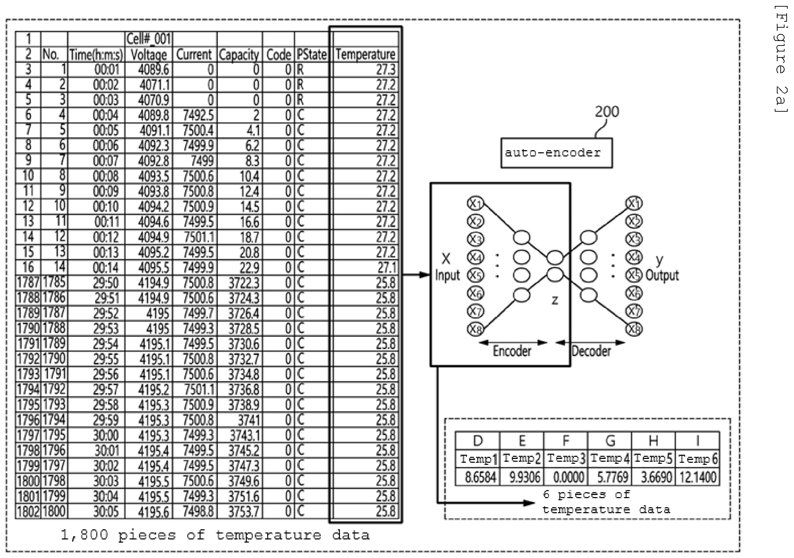

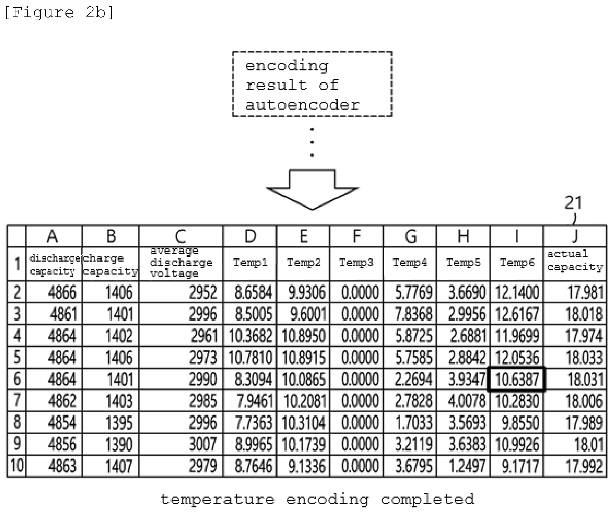

FIGS. 2a and 2b are conceptual diagrams of a temperature profile reduction operation using an auto-encoder according to embodiments of the present invention.

A battery cell is the basic unit of a battery configured to charge and discharge electrical energy. As battery cells undergo repeated charge and discharge cycles, their overall capacity decreases. Generally, as a battery deteriorates due to continuous use, the cell's internal resistance increases and the level of heat generated during charge and discharge increases compared to before.

Therefore, cell temperature is closely related to the cell's internal resistance and its capacity. The present invention uses cell temperature data to estimate cell capacity.

Embodiments of the present invention may estimate cell capacity using cell temperature profile data measured periodically (e.g., every second) during a battery activation process. Since the activation process is performed over a relatively long period of time and the temperature measurement cycle is relatively short, the cell temperature profile data periodically measured and collected may be massive.

Therefore, in embodiments of the present invention, cell temperature profile data may be compressed or reduced for use. To achieve this, embodiments of the present invention may utilize an auto-encoder to compress cell temperature profile data into six-dimensional data. An auto-encoder is a neural network that, upon inputting data, compresses (encodes) the data as much as possible, extracts data features, and then restores the data to its original input form. The auto-encoder consists of an encoder and a decoder.

Referring to FIGS. 2a and 2b, according to one embodiment of the present invention, for example, temperature profile data collected over 30 minutes (approximately 1,800 seconds of data) measured once per second from a device (e.g., a temperature sensor) measuring cell temperature may be compressed into six-dimensional data (six factors) using an auto-encoder. The configuration which is configured to encode temperature profile data into six-dimensional data according to the present embodiment has been established based on data obtained by the inventor through preliminary experiments. The inventor conducted preliminary experiments in which several other dimensional data such as 5-dimensional and 7-dimensional data were set as latent variables of an auto-encoder and the estimation capability for cell capacity estimation was measured. The experimental results showed that determining the temperature profile data as 6-dimensional data resulted in the best estimation capability. Accordingly, according to embodiments of the present invention, the latent variables of the auto-encoder are set to 6 dimensions, compressing the temperature profile data into 6-dimensional data.

If the temperature profile data is compressed several times over a given period, the resulting data (21) with temperature encoding completed can be obtained, as illustrated in FIG. 2b. Meanwhile, cell-related data according to embodiments of the present invention may include not only temperature data, but also discharge capacity, charge capacity, and an average discharge voltage.

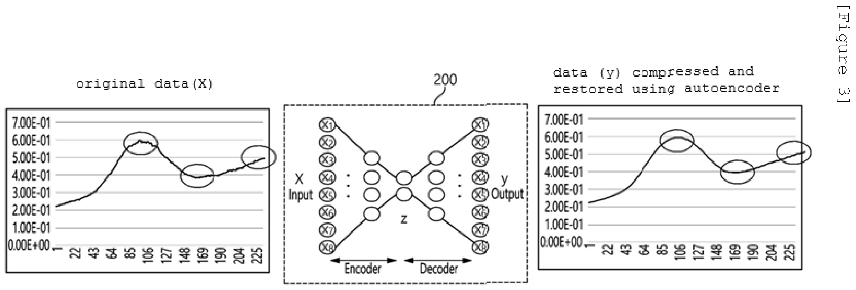

FIG. 3 is a diagram conceptually illustrating the operating principle of the auto-encoder applied to the present invention.

Referring to FIG. 3, the auto-encoder applied to the present invention may encode the original data (x), i.e., extracts one or more latent variables (latent vector) z as a result of the compression. Furthermore, examining the result (y) of data restored using the latent variable extracted as a result of the encoding, it is seen that the restored data (x') is very similar to the original data.

To enhance resilience, the auto-encoder may be pre-trained to minimize the difference between the input data and the restored data. This auto-encoder training may be performed in advance using mass-produced battery data. The mass-produced battery data may temperature profile data collected during a battery mass production process, specifically during a charge/discharge process in an activation process. For example, the mass-produced battery data may be in the form of the temperature data shown in FIG. 2.

More specifically, the encoder reduces the temperature profile data (x) to six dimensions and compresses it into a latent vector (z). The decoder reconstructs the latent vector into temperature profile data (x'). The reconstructed data (x') is compared with the input data (x) and the encoder and decoder parameters are updated to minimize the difference (reconstruction loss index). The updated encoder and decoder parameters are then used to repeat the compression, restoration, and reconstruction loss calculation processes. By repeating these processes, the autoencoder can be optimized for compressing (encoding) temperature profile data according to embodiments of the present invention.

The capability of autoencoder to successfully reconstruct the original data indicates that it has successfully extracted compressed latent variables from the original data. Therefore, the latent variables extracted by the autoencoder can be said to represent key features of the input data.

In the embodiments of the present invention, as described above, a machine learning model is trained using the temperature latent variables extracted using a pre-trained autoencoder and the trained machine learning model is used to predict the cell capacity.

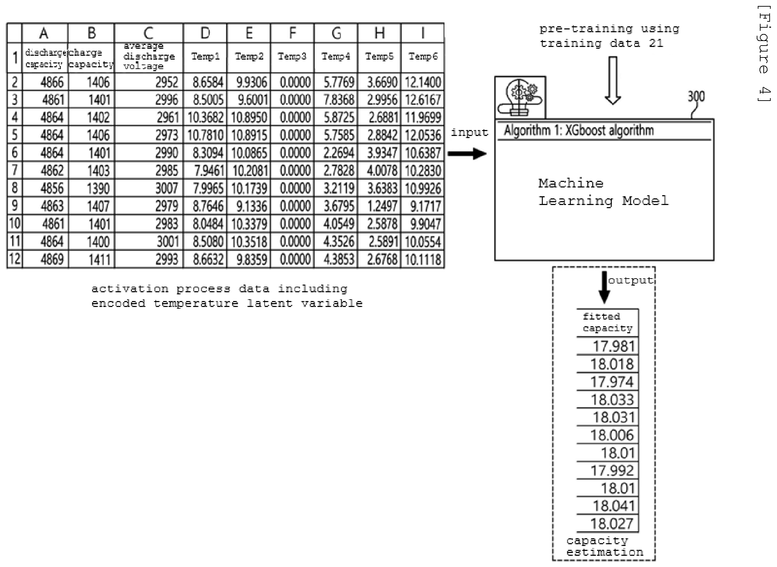

FIG. 4 is a conceptual diagram of a cell capacity estimation method using a machine learning model trained using a compressed temperature profile, according to embodiments of the present invention.

As illustrated in FIG. 3, when compressed temperature latent variables are extracted from temperature profile data using an auto-encoder, cell-related data 21 containing the compressed temperature latent variables are used as training data to pre-train a machine learning model 300.

Here, the machine learning model may be a model utilizing XGBoost. XGBoost is an open-source library used in machine learning and is an algorithm for predicting regression and classification problems.

Furthermore, in embodiments of the present invention, the cell-related data may include not only temperature data, but also discharge capacity, charge capacity, an average discharge voltage, and actual capacity. The cell-related data used to train the machine learning model may include discharge capacity, charge capacity, and an average discharge voltage obtained during a battery manufacturing process, as well as an actual cell capacity measured by discharging a cell under conditions identical to those used during battery use (at a slow discharge rate).

More specifically, the discharge capacity may be capacity measured when a cell is fully charged and then discharged during an activation process in mass production. During the activation process, operators discharge the cell at a faster rate than when the battery is actually used, so the discharge capacity measured at this time is likely to be inaccurate.

The charge capacity is capacity measured when a cell is fully discharged and then charged, during an activation process in mass production. During the activation process, operators charge the cell at a faster rate than when the battery is actually used, so the charge capacity measured at this time is likely to be inaccurate.

Additionally, the average discharge voltage is a voltage measured during mass production which may be calculated as an average of voltage values measured during cell discharge.

The actual capacity is a cell capacity measured when the cell is discharged under conditions identical to those during battery use, i.e., at a discharge rate which is not fast (a slower C-rate than that used during battery mass production), which provides an accurate value for the capacity.

Referring to FIG. 4, a machine learning model 300 pre-trained using cell-related data 21 may process activation process data which is input data to output a cell capacity estimation value. Here, the activation process data may include the previously described encoded temperature latent variable and data on discharge capacity, charge capacity, and an average discharge voltage obtained through measurements during the activation process.

Applying a large amount of uncompressed temperature profile data to a machine learning model inevitably imposes a significant computational burden. Therefore, the present invention applies six-factor temperature data encoded using an auto-encoder to the machine learning model.

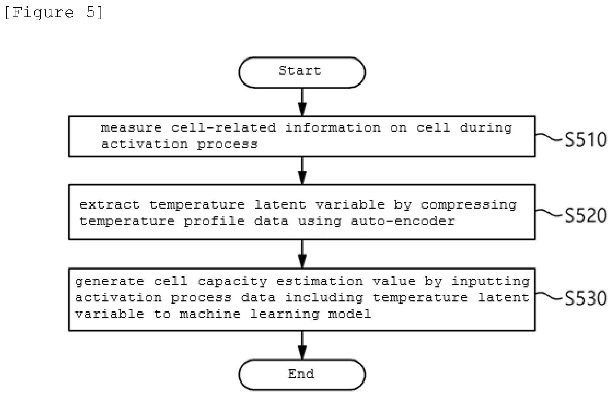

FIG. 5 is a flowchart illustrating a cell capacity estimation method according to embodiments of the present invention.

The cell capacity estimation method according to embodiments of the present invention may measure cell-related information during an activation process of a battery cell (S510) and use the cell-related information to estimate cell capacity. Here, the cell-related information may include cell discharge voltage, current, discharge capacity, charge capacity, temperature, etc., which may be measured periodically (e.g., once per second).

Once the cell-related information is acquired, temperature profile data from the cell-related information may be compressed to extract one or more temperature latent variables (S520). More specifically, the temperature profile data may be input to an auto-encoder, and temperature latent variables, which is the result of the auto-encoder encoding, are extracted.

Thereafter, activation process data including the temperature latent variable may be input to a pre-trained machine learning model to generate a cell capacity estimation value (S530). Here, the machine learning model may be in a state of pre-trained using cell-related data including compressed temperature latent variable as training data.

In embodiments of the present invention, the temperature latent variable may be expressed as a six-dimensional data as a characteristic parameter of the cell temperature profile data.

Here, the auto-encoder may be pre-trained using battery mass production data as input data and using a six-dimensional latent vector.

Meanwhile, the activation process data may include the temperature latent variable, the cell discharge capacity measured during the activation process, the cell charge capacity, and the average discharge voltage during cell discharge.

Furthermore, the cell-related data used as training data may include a temperature latent variable, a cell discharge capacity measured during an activation process, a cell charge capacity, an average discharge voltage during cell discharge, and a cell's actual capacity.

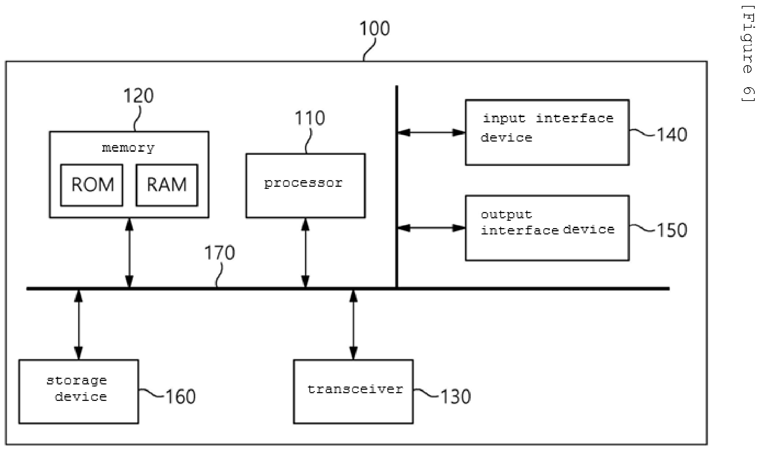

FIG. 6 is a block diagram of a cell capacity estimation apparatus according to embodiments of the present invention.

A battery cell capacity estimation apparatus 100 according to embodiments of the present invention may include at least one processor 110, a memory 120 storing at least one instruction executed by the at least one processor, and a transceiver 130 connected to a network and perform communication.

The battery cell capacity estimation apparatus 100 may be connected to one or more devices (e.g., a temperature sensor, a current sensor, a voltage measurement device, etc.) that measure cell-related information, and may receive cell-related measurements from the devices.

The at least one instruction executed by the at least one processor may include instruction to measure cell-related information during an activation process of the battery cell; an instruction to extract one or more temperature latent variables by compressing temperature profile data from the cell-related information; and an instruction to input activation process data including the one or more temperature latent variables into a pre-trained machine learning model to produce a cell capacity estimation value.

The instruction to extract the one or more temperature latent variables by compressing the temperature profile data from the cell-related information may include an instruction to input the temperature profile data into an auto-encoder; and an instruction to extract the one or more temperature latent variables as a result of encoding by the auto-encoder.

Here, the machine learning model may be pre-trained using cell-related data including a compressed temperature latent variable as training data.

The temperature latent variable may be a characteristic parameter of cell temperature profile data, expressed as six-dimensional data.

Here, the auto-encoder may be pre-trained using battery mass production data as input data, and using a six-dimensional latent vector.

In addition, the activation process data may include the one or more temperature latent variables, and the cell discharge capacity, the cell charge capacity, and the average discharge voltage during cell discharge which are measured during the activation process.

Meanwhile, the cell-related data used as the training data may include one or more temperature latent variables, cell discharge capacity measured during an activation process, cell charge capacity, an average discharge voltage during cell discharge, and an actual cell capacity.

Furthermore, the cell capacity estimation apparatus 100 according to embodiments of the present invention may further include an input interface device 140, an output interface device 150, a storage device 160, etc. Respective components included in the cell capacity estimation apparatus 100 may be connected by a bus 170 and can communicate with each other.

Here, the processor 810 may mean a central processing unit (CPU), a graphics processing unit (GPU), or a dedicated processor on which methods according to embodiments of the present invention are performed. The memory (or storage unit) may include at least one of a volatile storage medium and a nonvolatile storage medium. For example, the memory may include at least one of read only memory (ROM) and random access memory (RAM).

According to embodiments of the present disclosure, the correlation between estimated capacity value and actual cell capacity value can be improved. Consequently, the over-detection and under-detection rates for defect detection in cell capacity can be improved.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A method for estimating capacity of a battery cell, the method comprising:
measuring cell-related information during an activation process of the battery cell;
extracting one or more temperature latent variables by compressing temperature profile data from the cell-related information; and
inputting activation process data including the one or more temperature latent variables into a pre-trained machine learning model to generate a cell capacity estimation value.

2. The method of claim 1, wherein the extracting of the one or more temperature latent variables by compressing the temperature profile data from the cell-related information includes:
inputting the temperature profile data into an auto-encoder; and
extracting the one or more temperature latent variables as a result of encoding by the auto-encoder.

3. The method of claim 1, wherein the machine learning model is pre-trained using cell-related data including a compressed temperature latent variable as training data.

4. The method of claim 1, wherein the temperature latent variable is a characteristic parameter of cell temperature profile data, expressed as six-dimensional data.

5. The method of claim 2, wherein the auto-encoder is pre-trained using battery mass production data as input data, and using a six-dimensional latent vector.

6. The method of claim 1, wherein the activation process data includes the one or more temperature latent variables, and the cell discharge capacity, the cell charge capacity, and the average discharge voltage during cell discharge which are measured during the activation process.

7. The method of claim 3, wherein the cell-related data used as the training data includes one or more temperature latent variables, cell discharge capacity measured during an activation process, cell charge capacity, an average discharge voltage during cell discharge, and an actual cell capacity.

8. An apparatus for estimating capacity of a battery cell, the apparatus comprising:
at least one processor; and
a memory configured to store at least one instruction executed by the at least one processor,
wherein the at least one instruction includes:
an instruction to measure cell-related information during an activation process of the battery cell;
an instruction to extract one or more temperature latent variables by compressing temperature profile data from the cell-related information; and
an instruction to input activation process data including the one or more temperature latent variables into a pre-trained machine learning model to generate a cell capacity estimation value.

9. The apparatus of claim 8, wherein the instruction to extract the one or more temperature latent variables by compressing the temperature profile data from the cell-related information includes:
an instruction to input the temperature profile data into an auto-encoder; and
an instruction to extract the one or more temperature latent variables as a result of encoding by the auto-encoder.

10. The apparatus of claim 8, wherein the machine learning model is pre-trained using cell-related data including a compressed temperature latent variable as training data.

11. The apparatus of claim 8, wherein the temperature latent variable is a characteristic parameter of cell temperature profile data, expressed as six-dimensional data.

12. The apparatus of claim 9, wherein the auto-encoder is pre-trained using battery mass production data as input data, and using a six-dimensional latent vector.

13. The apparatus of claim 8, wherein the activation process data includes the one or more temperature latent variables, and the cell discharge capacity, the cell charge capacity, and the average discharge voltage during cell discharge which are measured during the activation process.

14. The apparatus of claim 10, wherein the cell-related data used as the training data includes one or more temperature latent variables, cell discharge capacity measured during an activation process, cell charge capacity, an average discharge voltage during cell discharge, and an actual cell capacity.
